# EUROPÄISCHE PATENTSCHRIFT

(11) **EP 3 011 390 B1**
(45) Veröffentlichungstag und Bekanntmachung des Hinweises auf die Patenterteilung: **21.02.2018**
(21) Anmeldenummer: 13731723.6
(22) Anmeldetag: 19.06.2013
(51) Int. Cl.: G03F 7/00

(54) **KOMBINATION AUS EINEM STEMPEL UND EINER PRÄGEMASSE FÜR DIE PRÄGELITHOGRAPHIE**
COMBINATION OF A STAMP AND AN IMPRINTING MATERIAL FOR IMPRINTING LITHOGRAPHY
COMBINAISON D'UN TAMPON ET D'UNE MATIÈRE D'IMPRESSION POUR LA LITHOGRAPHIE PAR IMPRESSION

(43) Veröffentlichungstag der Anmeldung: 27.04.2016
(60) Teilanmeldung: 17209605.9
(73) Patentinhaber: Ev Group E. Thallner GmbH, 4782 St. Florian am Inn (AT)
(72) Erfinder: CHOUIKI, Mustapha, A-4020 Linz (AT)
(74) Vertreter: Schneider, Sascha
(86) Internationale Anmeldenummer: PCT/EP2013/062711
(87) Internationale Veröffentlichungsnummer: WO 2014/202127

(56) Entgegenhaltungen:
- WO-A1-2012/053543
- WO-A2-03/086959
- WO-A2-2007/127984
- US-A1- 2005 202 350
- US-A1- 2008 277 826
- US-A1- 2009 189 317
- US-A1- 2009 256 287
- US-A1- 2010 155 989
- US-A1- 2011 305 787

## Beschreibung

Die Erfindung betrifft eine Kombination aus einem Stempel mit einer hydrophoben Stempeloberfläche und einer für die Prägelithographie verwendbaren, härtbaren Prägemasse mit einer hydrophoben Oberfläche gemäss Anspruch 1. In der Halbleiterindustrie werden zunehmend Prägelithographieverfahren eingesetzt, um klassische, optische Lithographieverfahren zu ergänzen oder zu ersetzen. Durch die Verwendung von mikro- und/oder nanostrukturierten Prägestempeln erhält man eine mechanische, nicht auf optische Beugungsphänomene beschränkte, Möglichkeit der Strukturierung zähflüssiger Prägemassen. Die strukturierten, zähflüssigen Prägemassen werden vor und/oder während des Prägevorganges vernetzt/gehärtet, um formstabil zu bleiben. Die Vernetzung erfolgt dabei insbesondere über elektromagnetische Strahlung, mit Vorzug UV Licht und/oder mittels Wärme, also thermisch. Nach der Vernetzung kann der Prägestempel aus der gehärteten Prägemasse entfernt werden. Die zurückbleibende, gehärtete Prägemasse besitzt entweder bereits eine funktionelle Form oder wird in anschließenden Prozessschritten weiterbehandelt. Sehr viele, vor allem auf anorganischen Molekülen basierende, Prägemassen werden nach dem Entformungsschritt noch bei sehr hohen Temperaturen wärmebehandelt. Die Wärmebehandlung sorgt dafür, dass die Prägemasse irreversibel ausgehärtet wird. Bei der Verwendung von Prägemassen mit organischen und anorganischen Molekülen sorgt die Wärmebehandlung vorwiegend dafür, dass organische Teile aus der Prägemasse entfernt werden und die anorganischen Moleküle miteinander vernetzen. Dadurch ist es möglich, eine Prägemasse bestehend aus organischen und anorganischen Molekülen durch Stempelprozesse zu strukturieren und nach dem Stempelprozess in ein vollständig anorganisches Material überzuführen.

Um die Strukturierung der Prägemasse durchzuführen, benötigt man spezielle Prägestempel. Die Prägestempel müssen extrem hohen Anforderungen entsprechen, damit deren mikro- und/oder nanometergroße Strukturen fehlerfrei als Negativ in die Prägemasse übertragen werden können. Im Stand der Technik existieren viele unterschiedliche Stempelarten. Man unterscheidet grundsätzlich zwischen Hart- und Weichstempel.

Ein Hartstempel besteht aus Metall, Glas oder Keramik. Er ist wenig verformbar, korrosionsbeständig, verschleißfest und sehr teuer in der Herstellung. Die Oberfläche des Hartstempels wird meistens durch Elektronenstrahllithographie oder Laserstrahllithographie bearbeitet. Diese Herstellverfahren sind im Allgemeinen sehr teuer. Der Vorteil der Hartstempel liegt vor allem in der hohen Verschleißbeständigkeit. Ein entscheidender Nachteil besteht im hohen Biegewiderstand, welcher es nicht zulässt, den Prägestempel stückweise von der Prägemasse abzuziehen, wie das bei Weichstempeln möglich ist. Der Hartstempel kann nur über seine gesamte Fläche durch eine Normalkraft von der Prägemasse abgehoben werden.

Ein Weichstempel wird sehr oft als Negativ eines Hartstempels abgeformt. Er besteht meistens aus einem Polymer, besitzt eine hohe Elastizität und eine geringe Biegefestigkeit. Er ist meistens entropieelastisch. Der Grund ist vor allem eine hohe Adhäsion zwischen der Prägemasse und dem Weichstempel und/oder ein Aufschwellen des Weichstempels. Weichstempel können durch unterschiedliche chemische, physikalische und technische Parameter von Hartstempel unterschieden werden. Denkbar wäre eine Unterscheidung aufgrund des Elastizitätsverhaltens. Weichstempel besitzen ein vorwiegend auf Entropieelastizität, Hartstempel vorwiegend auf Energieelastizität, beruhendes Verformungsverhalten. Des Weiteren können die beiden Stempelarten beispielsweise über ihre Härte unterschieden werden. Die Härte ist der Widerstand, den ein Material einem eindringenden Körper entgegenstellt. Da Hartstempel vorwiegend aus Metallen oder Keramiken bestehen, besitzen sie entsprechend hohe Härtewerte. Es gibt unterschiedliche Möglichkeiten die Härte eines Festkörpers anzugeben. Eine sehr gebräuchliche Methode ist die Angabe der Härte nach Vickers. Ohne auf Einzelheiten einzugehen kann man grob sagen, dass Hartstempel Vickershärten jenseits von 500 HV besitzen werden. Theoretisch sollten solche Weichstempel sehr einfach von der Prägemasse entfernbar sein, was aber häufig nicht der Fall ist. Die größten Probleme mit den heutigen Prägetechniken bestehen somit vor allem beim Entformungsschritt, also bei der Trennung des Prägestempels, insbesondere Weichstempels, aus der Prägemasse.

Aufgabe der vorliegenden Erfindung ist es daher, eine Prägemasse vorzusehen, die besser von dem Prägestempel lösbar ist.

Diese Aufgabe wird mit den Merkmalen des Anspruchs 1 gelöst. Vorteilhafte Weiterbildungen der Erfindung sind in den Unteransprüchen angegeben. In den Rahmen der Erfindung fallen sämtliche Kombinationen von Merkmalen aus der Beschreibung und/oder den Figuren, sofern diese von den Ansprüchen.gestützt werden. Bei angegebenen Wertebereichen sollen auch innerhalb der genannten Grenzen liegende Werte als Grenzwerte offenbart gelten und in beliebiger Kombination beanspruchbar sein.

Die Erfindung beschreibt eine Kombination aus einem Stempel mit einer hydrophoben Stempeloberfläche und einer für die Prägelithographie verwendbaren, härtbaren Prägemasse mit einer hydrophoben Oberfläche gemäss Anspruch 1. Die Prägemasse zeichnet sich durch eine Mischung mindestens einer, mit Vorzug aus anorganischen und/oder organischen Teilen bestehenden, Hauptkomponente, und mindestens einer, insbesondere zur Einstellung der Wechselwirkungseigenschaft der Prägemasse mit Wasser geeignete/verwendete, Nebenkomponente, mit Vorzug einer organischen Komponente, aus. Unter einer Hauptkomponente versteht man eine Komponente, die im überwiegenden Ausmaß zum Aufbau der endgültigen geprägten Form beiträgt. Unter einer Nebenkomponente versteht man alle anderen Komponenten, die mit der Hauptkomponente gemischt werden, dazu zählen vor allem jene organischen Komponenten, mit deren Hilfe erfindungsgemäß die Hydrophilität bzw. Hydrophobizität eingestellt/beeinflusst wird, Initiatoren und Lösungsmittel. Erfindungsgemäß kann die Prägemasse daher auch aus mehreren Hauptkomponenten und/oder mehrere Nebenkomponenten bestehen. Im weiteren Verlauf wird exemplarisch nur mehr von einer Haupt- und einer Nebenkomponente gesprochen werden, obwohl erfindungsgemäß mehrere Haupt- und/oder mehrere Nebenkomponenten in der erfindungsgemäßen Prägemasse vorgesehen sein können.

Erfindungsgemäß gibt es also eine erste Komponenten, die Hauptkomponente. Die zweite Komponente ist eine Komponente, mit Vorzug eine organische Verbindung, welche maßgeblich zur erfindungsgemäßen Einstellung der Hydrophilität bzw. Hydrophobizität dient. Die dritte Komponente ist ein Lösungsmittel. Die vierte Komponente ist ein Initiator, mit Vorzug ein Photoinitiator, welcher die Polymerisation zwischen den Hauptkomponenten startet. Diese, aus mindestens vier Komponenten bestehende Mischung, wird durch einen Beschichtungsprozess auf einem Substrat abgeschieden. Das Lösungsmittel überwiegt mit seinen Massenprozent zumindest vor der Urformung der Prägemasse bei weitem die Massenprozente der Hauptkomponente. Der Massenprozentanteil der Hauptkomponente ist kleiner als 10%, mit Vorzug kleiner als 8%, mit größerem Vorzug kleiner als 6%, mit noch größerem Vorzug kleiner als 4%, mit größtem Vorzug kleiner als 3%. Der Massenprozentanteil der für die Einstellung der Hydrophilität bzw. Hydrophobizität maßgeblich verantwortlichen zweiten Komponente, ist kleiner als 2%, mit Vorzug kleiner als 1.5%, mit größerem Vorzug kleiner als 1.0%, mit noch größerem Vorzug kleiner als 0.5%, mit größtem Vorzug kleiner als 0.1%. Der Massenprozentanteil des verwendeten Initiators, mit Vorzug eines Photoinitiators, ist kleiner als 2%, mit Vorzug kleiner als 1.5%, mit größerem Vorzug kleiner als 1.0%, mit noch größerem Vorzug kleiner als 0.5%, mit größtem Vorzug kleiner als 0.2%. Der Massenprozentanteil des verwendeten Lösungsmittels ist kleiner als 98%, mit Vorzug kleiner als 96%, mit größerem Vorzug kleiner als 94%, mit noch größerem Vorzug kleiner als 92%, mit größtem Vorzug kleiner als 90%. Nachdem das Lösungsmittel aus der Mischung entfernt wurde bzw. sich verflüchtigt hat, ändern sich die Massenprozente der erfindungsgemäßen Prägemasse entsprechend.

Über die, insbesondere organische, Nebenkomponente können Polymerisation, Schrumpfung und/oder Adhäsion gezielt eingestellt oder zumindest beeinflusst werden. Mit Vorzug wird die organische Nebenkomponente so gewählt, dass die Adhäsion zwischen Prägemasse und Prägestempel möglichst klein ist, und damit eine einfache Entformung des Prägestempels von der Prägemasse ermöglicht wird. Insbesondere wird für eine möglichste einfache Entformung die Oberfläche der Prägemasse hydrophob gewählt, wenn die Prägestempeloberfläche hydrophil ist und umgekehrt. Für die Entformung wird gemäß der Erfindung eine Kombination aus hydrophober Stempeloberfläche und hydrophober Oberfläche der Prägemasse eingesetzt. Die optimale Kombination kann erfindungsgemäß empirisch bestimmt werden. Unter Hydrophilität versteht man die hohe Wechselwirkungsfähigkeit der Oberfläche eines Stoffes mit Wasser. Hydrophile Oberflächen sind vorwiegend polar und interagieren mit den permanenten Dipolen der Moleküle von Fluiden, bevorzugt mit Wasser, entsprechend gut. Die Hydrophilität einer Oberfläche wird mit Hilfe eines Kontaktwinkelmessgeräts quantifiziert. Hydrophile Oberflächen besitzen dabei sehr geringe Kontaktwinkel. Unter Hydrophobie versteht man entsprechend die geringe Wechselwirkungsfähigkeit der Oberfläche eines Stoffes mit Wasser.

Hydrophobe Oberflächen sind vorwiegend unpolar und interagieren kaum mit den permanenten Dipolen der Moleküle von Fluiden. Die erfindungsgemäße Prägemasse der Erfindung weist eine hydrophobe Oberfläche auf, um möglichst einfach vom Stempel entformt werden zu können. Erfindungsgemäss gelten folgende Wertebereich:
Eine hydrophobe Oberfläche besitzt erfindungsgemäß einen Kontaktwinkel größer als 90°, mit Vorzug größer als 100°, mit größerem Vorzug größer als 120°, mit noch größerem Vorzug größer als 140°, mit allergrößtem Vorzug größer als 160°. Gemäß einem weiteren, insbesondere eigenständigen Aspekt der Erfindung ist eine Prägemasse vorgesehen, bei welcher das Mischungsverhältnis zwischen einer Haupt- und mindestens einer Nebenkomponente so eingestellt wird, dass die daraus resultierende Prägemasse nach einem Prägevorgang durch einen Prägestempel durch die niedrige Adhäsionseigenschaft der Prägemasse zum Prägestempel von diesem ohne Schaden der geprägten Struktur gelöst werden kann. Die Hauptkomponente ist dabei mit Vorzug eine organisch/anorganische Verbindung. Die Nebenkomponente ist dabei mit Vorzug eine organische Verbindung.

Bei der Hauptkomponente handelt es sich mit Vorzug um ein Silsesquioxan. Erfindungsgemäß wird die Hauptkomponente ausgewählt aus den folgenden Materialien:
- Polyhedrales oligomerisches Silsesquioxan (POSS)
- Poly(organo)siloxane (Silikon)

Die Nebenkomponenten können aus jeder beliebigen organischen und/oder anorganischen Verbindung bestehen. Die Nebenkomponenten sind hauptverantwortlich für die Einstellung der erfindungsgemäßen Hydrophilität oder Hydrophobizität, welche die erleichterte Entformung des Stempels von der erfindungsgemäßen Prägemasse erlaubt. Mit besonderem Vorzug besitzen die Nebenkomponenten entsprechende funktionelle Gruppen, die die Hydrophilität bzw. Hydrophobizität beeinflussen. Diese Nebenkomponenten können einen beliebig komplizierten, mit Vorzug organischen, Aufbau besitzen. Da es nicht möglich ist, alle möglichen Verbindungen aufzuzählen, die erfindungsgemäß die Hydrophilität bzw. Hydrophobizität der erfindungsgemäßen Prägemasse beeinflussen können, werden stattdessen einige Sammelbezeichnungen chemischer Substanzen und/oder funktionelle Gruppen genannt. Entsprechend können sich Verbindungen aus einer Kombination der Elemente der folgenden Liste zusammensetzen. Alle in der Liste vorkommenden chemischen Verbindungen können als Monomer oder Polymer eingesetzt werden. Bei mindestens einer der Nebenkomponenten handelt es sich mit Vorzug um eine organische, insbesondere eine der folgenden Verbindungen:
- (Poly)Acrylat
- Ether. In einer ganz besonderen Ausführungsform kann die Nebenkomponente der gleichen funktionalen Gruppe angehören wie die organischen, funktionellen Gruppen der Hauptkomponente.

Lösungsmittel werden immer verwendet, um die Hauptkomponente, die Initiatoren und die erfindungsgemäße organische Komponente, mit deren Hilfe die Einstellung und/oder Beeinflussung der Hydrophilität bzw. Hydrophobizität erfolgt, zu lösen. Mit Vorzug werden die Lösungsmittel im Laufe des Herstellprozesses der eigentlichen Struktur aus der erfindungsgemäßen Prägemasse entfernt bzw. entweichen von selbst. Mit Vorzug wird eines der folgenden Lösungsmittel verwendet:
- Aceton
- Acetonitril
- Anilin
- Cyclohexan
- n-Pentan
- Triethylenglycoldimethylether (Triglyme)
- Dimethylacetamid
- Dimethylformamid
- Dimethylsulfoxid
- 1,4-Dioxan
- Eisessig
- Essigsäureanhydrid
- Essigsäureethylester
- Ethanol
- Ethylendichlorid
- Ethylenglycol
- Anisol
- Benzol
- Benzonitril
- Ethylenglycoldimethylether
- Petrolether/Leichtbenzin
- Piperidin
- Propanol
- Propylencarbonat (4-Methyl-1,3-dioxol-2-on)
- Pyridin
- γ-Butyrolacton
- Chinolin
- Chlorbenzol
- Chloroform
- n-Heptan
- 2-Propanol (Isopropylalkohol)
- Methanol
- 3-Methyl-1-butanol (Isoamylalkohol)
- 2-Methyl-2-propanol (tert-Butanol)
- Methylenchlorid
- Methylethylketon (Butanon)
- N-Methyl-2-pyrrolidon (NMP)
- N-Methylformamid
- Tetrahydrofuran
- Milchsäureethylester
- Toluol
- Dibutylether
- Diethylenglycol
- Diethylether
- Brombenzol
- 1-Butanol
- tert-Butylmethylether (TBME)
- Triethylamin
- Triethylenglycol
- Formamid
- n-Hexan
- Nitrobenzol
- Nitromethan
- 1,1,1-Trichlorethan
- Trichlorethen
- Schwefelkohlenstoff
- Sulfolan
- Tetrachlorethen
- Tetrachlorkohlenstoff
- Propylen glycol monomethly ether acetat (PGMEA)
- Wasser.

Die Hauptkomponenten und die Nebenkomponenten werden zusammen mit Initiatoren, welche die Kettenreaktion starten, in einem entsprechenden stöchiometrisch korrekten Verhältnis gemischt. Durch das Mischen der Haupt- mit der Nebenkomponente und dem Initiator kommt es bei Aktivierung des Initiators zu einer Polymerisation zwischen organischen Teilen der Hauptkomponenten. Es polymerisieren nur die Hauptkomponenten untereinander. Bei der Polymerisation entstehen langkettige Moleküle und/oder ganze 2D- und/oder 3D-Netzwerke, mit Vorzug mit einer speziell einstellbaren Anzahl von Monomeren. Die Anzahl der Monomere ist dabei größer als 1, mit Vorzug größer als 10, mit größerem Vorzug größer als 100, mit größtem Vorzug größer als 1000, mit allergrößtem Vorzug polymerisieren die Monomere zu einem vollständigen 2D- und/oder 3D-Netzwerk.

Durch das Mengenverhältnis zwischen der Haupt- und den Nebenkomponenten kann erfindungsgemäß die Hydrophilität (bzw. die Hydrophobizität) der Prägemasse eingestellt werden. Da die Hauptkomponente vorzugsweise zumindest überwiegend, insbesondere vollständig, ein vorwiegend anorganisches Material ist, mit Vorzug ein Silsesquioxan, wird die Hydrophilität bzw. Hydrophobizität mit Vorzug über die Art und die Menge der Nebenkomponente bestimmt. Die Oberfläche der verwendeten Prägestempel wird hydrophob gewählt. Der Erfindung liegt eine Kombination einer hydrophobe Oberfläche einer Prägemasse mit einem hydrophoben Stempel zugrunde. Mit Vorteil weist die Prägemasse eine möglichst geringe Adhäsion zum Prägestempel auf. Die Adhäsionsfähigkeit zwischen zwei Oberflächen lässt sich am besten durch eine Energie pro Einheitsfläche, also eine Energieflächendichte, beschreiben. Darunter versteht man die Energie die notwendig ist, um zwei miteinander verbundene Oberflächen entlang der Einheitsfläche wieder voneinander zu trennen. Die Adhäsion zwischen Prägemasse und Prägestempel wird erfindungsgemäß insbesondere kleiner als 2.5 J/m², mit Vorzug kleiner als 1 J/m², mit größerem Vorzug kleiner als 0.1 J/m², mit noch größerem Vorzug kleiner als 0.01 J/m², mit größtem Vorzug kleiner als 0.001 J/m², mit allergrößtem Vorzug kleiner als 0.0001 J/m², am bevorzugtesten kleiner als 0.00001 J/m² eingestellt. Gemäss der Erfindung besteht die Prägemasse aus mindestens, insbesondere genau, vier Komponenten. Die Hauptkomponente ist eine auf Siliziumoxid basierende chemische Verbindung, mit Vorzug ein Silsesquioxan, während die Nebenkomponente mit Vorzug eine, insbesondere rein, organische Verbindung ist. Die dritte Komponente ist ein Lösungsmittel. Die vierte Komponente ist ein Initiator, mit Vorzug ein Photoinitiator, welcher die Polymerisation zwischen den Hauptkomponenten startet. Diese, aus mindestens vier Komponenten bestehende Mischung, wird durch einen Beschichtungsprozess auf einem Substrat abgeschieden. Das Lösungsmittel überwiegt mit seinen Massenprozent bei weitem die Massenprozente der Hauptkomponente, der Nebenkomponente und der Initiatoren. Der Massenprozentanteil der Hauptkomponente ist kleiner als 10%, mit Vorzug kleiner als 8%, mit größerem Vorzug kleiner als 6%, mit noch größerem Vorzug kleiner als 4%, mit größtem Vorzug kleiner als 3%. Der Massenprozentanteil der für die Einstellung der Hydrophilität bzw. Hydrophobizität maßgeblich verantwortlichen Nebenkomponente, ist kleiner als 2%, mit Vorzug kleiner als 1.5%, mit größerem Vorzug kleiner als 1.0%, mit noch größerem Vorzug kleiner als 0.5%, mit größtem Vorzug kleiner als 0.1%. Der Massenprozentanteil des verwendeten Initiators, mit Vorzug eines Photoinitiators, ist kleiner als 2%, mit Vorzug kleiner als 1.5%, mit größerem Vorzug kleiner als 1.0%, mit noch größerem Vorzug kleiner als 0.5%, mit größtem Vorzug kleiner als 0.2%. Der Massenprozentanteil des verwendeten Lösungsmittels ist kleiner als 98%, mit Vorzug kleiner als 96%, mit größerem Vorzug kleiner als 94%, mit noch größerem Vorzug kleiner als 92%, mit größtem Vorzug kleiner als 90%. Nachdem das Lösungsmittel aus der Mischung entfernt wurde bzw. sich verflüchtigt hat, ändern sich die Massenprozente der erfindungsgemäßen Prägemasse entsprechend.

Den Prägemassen werden insbesondere Thermo- und/oder Photoinitiatoren hinzugefügt, um die Prägemasse zu vernetzen (engl.: curing) und um sie, insbesondere irreversibel, in eine ausgehärtete Form zu bringen. Erfindungsgemäß bevorzugte Photoinitiatoren reagieren sensitiv im Bereich zwischen 100nm und 1000nm, mit Vorzug zwischen 200nm und 500nm, mit größerem Vorzug zwischen 300nm und 400nm. Thermoinitiatoren starten die Vernetzung zwischen 25°C und 400°C, mit Vorzug zwischen 50°C und 300°C, mit größerem Vorzug zwischen 100°C und 200°C.

Nach dem Vernetzungsvorgang wird der Prägestempel aus der Prägemasse entfernt. Die erfindungsgemäßen Prägemassen eigenen sich nicht ausschließlich, aber vor allem, für Prägeprozesse, bei denen der Prägestempel nicht unter einer reinen vollflächigen Normalkraft, sondern durch einen Peel- oder Rollprozess von der Prägemasse entfernt wird. Für Weichstempel ist es üblich, den Weichstempel von der Prägemasse abzuziehen, anstatt abzuheben. Bei dieser Art der Entformung muss die Kraft nur für die Trennung zwischen Prägestempel und Prägemasse entlang der Trennlinie/Trennfront, an welcher die Trennung erfolgt, aufgebracht werden.

In einem weiteren, erfindungsgemäß optionalen Prozessschritt wird die Prägemasse einem Hochtemperaturprozess zugeführt, um sie zu Sintern. Beim Sintervorgang werden mit Vorzug alle organischen Reste in der Prägemasse oxidiert und aus der Prägemasse entfernt, sodass eine reine, mit Vorzug anorganische Struktur, mit größtem Vorzug eineSiO₂-Struktur zurück bleibt. Das Sintern erfolgt insbesondere bei mehr als 50°C, mit Vorzug bei mehr als 200°C, mit größerem Vorzug bei mehr als 400°C, mit größtem Vorzug bei mehr als 600°C, mit allergrößtem Vorzug bei mehr als 800°C, am bevorzugtesten bei mehr als 1000°C.

Besonders effizient erfolgt die Oxidation der organischen Reste in der Prägemasse in einer Atmosphäre mit hohem Sauerstoffanteil. Der Sauerstoffanteil ist insbesondere größer als 20 %, mit Vorzug größer als 60%, mit größerem Vorzug mehr als 80%, mit allergrößtem Vorzug an die 100%. Denkbar wären auch besondere Sinteratmosphären aus einer hochoxidierenden Komponente wie Sauerstoff und einer Inertgaskomponente wie Stickstoff, Argon, Helium oder Kohlendioxid.

Die erfindungsgemäße Prägemasse kann für unterschiedliche Anwendungen verwendet werden, besonders bevorzugt für folgende Verwendungen:
Die Prägemasse kann als Schutzmasse oder als Einkapselungsmasse verwendet werden. Dazu wird die Prägemasse, in einem ersten erfindungsgemäßen Schritt über der zu schützenden Struktur aufgebracht. Danach erfolgt mit Vorzug entweder einer Planarisierung der Prägemasse durch einen nicht strukturierten, ebenen Prägestempel oder eine Strukturierung durch einen strukturierten Prägestempel. Die Planarisierung der erfindungsgemäßen Prägemasse dient insbesondere für einen weiteren Prozessschritt, welcher eine ebene Fläche voraussetzt. Die Strukturierung der erfindungsgemäßen Prägemasse erlaubt die Funktionalisierung der eigentlich nur als Schutzmasse vorgesehenen Prägemasse. Denkbar wäre die Verwendung für die Prägung einer Linse, eines oder mehrerer Kanäle für Ivlikrofluidgeräte, einer Kavität für MEMs oder eine Strukturierung für ein weiteres funktionales Bauteil über der zu schützenden oder einzukapselnden Struktur. Die Schutzmasse kann als Schutzschicht unterschiedliche Aufgaben erfüllen. Ist die Schutzschicht optisch transparent, erlaubt sie eine elektrische und/oder magnetische Isolation der darunterliegenden Bauteile, ohne die Transparenz für elektromagnetische Strahlen in gewissen Wellenlängenbereichen einzuschränken. Damit wäre insbesondere die Kommunikation zwischen zwei optoelektronischen Bauteilen durch die Schutzmasse noch denkbar. Bauteilgruppen könnten von der Umgebung elektrisch und/oder magnetisch isoliert werden und dennoch kommunizieren. Die Schutzmasse ist insbesondere elektrisch isolierend. Elektrische Isolation ist eine Eigenschaft von Dielektrika. Vor allem SiO₂-basierte Materialien sind aufgrund ihrer Bindungsstruktur und ihrer Bandstruktur besonders geeignet, um Bauteile elektrisch zu isolieren. Damit erfolgt eine galvanische Trennung von der Umgebung. Die Schutzmassen sind bevorzugt sehr thermostabil. Da vor allem anorganische Materialien, im Besonderen Oxidkeramiken, sehr hohe Schmelzpunkte aufweisen, kann mit der erfindungsgemäßen Ausführungsform eine bis zu sehr hohen Temperaturen stabile Schutzhülle geschaffen werden. Des Weiteren sind die erfindungsgemäßen Prägemassen vor allem chemisch inert. Das macht sie widerstandsfähig gegen Säuren, Basen, Oxidation, Reduktion. Diese genannten chemischen Beeinträchtigungen können entweder während der weiteren Prozessierung der Bauteile oder im späteren Einsatz auftreten.

In einer ganz bevorzugten, insbesondere eigenständigen, Ausführungsform der vorliegenden Erfindung wird die Prägemasse durch einen Abscheideprozess aufgebracht und verbleibt in der entsprechenden Verteilung an der Oberfläche ohne durch einen Planarisierungsprozess oder einen Prägeprozess verändert zu werden. Die Prägemasse könnte beispielsweise durch einen Sprühbelackungspozess mit einer extrem geringen Dicke über die zu schützenden Strukturen aufgebracht werden. Diese besondere Ausführungsform hat den Vorteil, dass die Prägemasse noch der Topographie der Oberfläche folgt und diese nicht vollends bedeckt. Eine weitere Anwendungsmöglichkeit wäre die Verteilung einer, mit Vorzug im Zentrum aufgebrachten, Prägemasse durch einen Schleuderbelackungsprozess. Diese Variante würde sich vor allem für ebene Strukturen eignen, die geschützt werden müssen. Sollte die erfindungsgemäße Prägemasse eine Dicke besitzen, die um ein Vielfaches größer ist als die zu schützenden Strukturen, kann die Schleuderbelackung auch erfolgreich zur Abscheidung verwendet werden. Nach den genannten Prozessschritten erfolgt eine irreversible Aushärtung der Prägemasse durch mindestens eine der bereits genannten Methoden.

In einer zweiten, insbesondere eigenständigen, Ausführungsform wird die erfindungsgemäße Prägemasse als Grundmasse für unterschiedliche funktionale Einheiten verwendet. Die erfindungsgemäße Prägemasse ist dabei selbst Ausgangsmaterial und schützt nicht wie in der zuvor erwähnten erfindungsgemäßen Ausführungsform eine Struktur, sondern dient als Bausubstanz. Denkbar wäre die Prägung vom MEMS Baugruppen (engl. MEMS devices), Mikrofluidbaugruppen (engl.: microfluidic devices) oder photonischen Kristallen. Die erfindungsgemäße Prägemasse wird dabei mit Vorzug auf ein Substrat aufgebracht. Obwohl wiederum jeder bekannte Abscheidungsprozess zur Auftragung der erfindungsgemäßen Prägemasse auf dem, mit Vorzug vollkommen ebenen, Substrats erfolgen kann, eignet sich für diese Ausführungsform vor allem die Schleuderbelackung. In einem ersten Prozessschritt wird eine Pfütze der erfindungsgemäßen Prägemassen an einer Stelle des Substrats, mit Vorzug dem Zentrum, aufgebracht. Danach verteilt ein Schleuderbelackungsprozess die erfindungsgemäße Prägemasse gleichmässig über die gesamte Oberfläche des Substrats. Dabei ist die Schichtdicke der erfindungsgemäßen Ausführungsform mit Vorzug vollkommen homogen. In einem zweiten Prozessschritt erfolgt die Prägung der erfindungsgemäßen Prägemasse mit einem Prägestempel. Die Struktur des Prägestempels wird dabei als Negativ in die erfindungsgemäße Prägemasse übertragen. Denkbar wären beispielsweise die Herstellung von Prozesskammern, Kanälen, Mischungskammern, allgemeine Kavitäten etc., die man vorwiegend für die Herstellung von Mikrofluidbauteilen benötigt. Des Weiteren wäre die Herstellung von Kavitäten für MEMS Baugruppen oder LED Baugruppen denkbar. Durch diese Ausführungsform werden insbesondere Teile von Baugruppen hergestellt, die alleine nicht vollständig funktionstüchtig sind. Im Allgemeinen wird die Strukturierung der erfindungsgemäßen Prägemasse offenbart. Unmittelbar nach den genannten Prozessschritten erfolgt eine irreversible Aushärtung der Prägemasse durch mindestens eine der bereits genannten Methoden. Der Vorzug dieser Ausführungsform ist vor allem bei der Herstellung von Mikrofluidbaugruppen erkennbar. Mikrofluidbaugruppen zeichnen sich durch Kanäle, Reaktionskammern, Mischkammern, Pumpenkammern und/oder Analysekammern aus. Die unterschiedlichen Kammern sind über die Kanäle miteinander verbunden. Mikrofluidbaugruppen transportieren nun Fluide, Gase und/oder Flüssigkeiten von einer Stelle der Mikrofluidbaugruppe zu einer zweiten Stelle, wobei das Fluid eine oder mehrere der Kammern durchläuft. In den Kammern finden insbesondere physikalische und/oder chemische Prozesse statt. Diese Prozesse verändern entweder das Fluid oder erlauben die Erzeugung eines physikalischen Messsignals, mit dessen Hilfe man eine Aussage über das Fluid erhält. Ein typischer chemischer Prozess wäre ein Mischvorgang in einer Mischkammer zwischen einem ersten Fluid und einem zweiten Fluid. Ein weiterer chemischer Vorgang wäre insbesondere die Reaktion eines ersten Fluids und eines zweiten Fluids zu einem dritten Fluid in einer Reaktionskammer. Ein typischer physikalischer Vorgang wäre die Beaufschlagung eines Fluids mit einem Laser, der das Fluid zur Fluoreszenz anregt. Die emittierte Strahlung kann dann entsprechend detektiert werden und erlaubt Aussagen über das Fluid. Eine der wichtigsten Verwendungen von Mikrofluidbaugruppe ist die Sequenzierung von Makromolekülen, mit Vorzug von DNA Fragmenten, mit besonderem Vorzug ganzer DNA-Stränge. Dabei spielt sich in der Mikrofluidbaugruppe bevorzugt folgender Prozess ab. Eine Lösung mit einem zu sequenzierenden Makromolekül wird in die Mikrofluidbaugruppe eingebracht. In einer ersten Reaktionskammer binden Teile der zu sequenzierenden Makromoleküle an der Oberfläche der Reaktionskammer. Mit Vorzug binden die zu sequenzierenden Makromoleküle mit ihren beiden Enden an der Oberfläche, sodass sie einen molekularen "Torbogen" bilden, also bogenförmig biegen. In einem weiteren Schritt werden die so gebundenen Makromoleküle repliziert, indem eine Lösung mit entsprechenden Bausteinen in die Mikrofluidbaugruppe eingebracht wird. Nach der erfolgreichen Replikation der Makromoleküle werden diese seriell sequenziert, indem definierte Markermoleküle, deren funktionale Gruppe an Teile der zu sequenzierenden Makromoleküle andocken kann, abwechselnd die Mikrofluidbaugruppe durchströmen. Erfolgt ein Andocken der Markermoleküle an die zu sequenzierenden Makromoleküle, kann ein entsprechender Sensor, mit Vorzug ein optischer Sensor, welcher die Wechselwirkung von in die Mikrofluidbaugruppe eingestrahlter elektromagnetischer Strahlung mit den Markermoleküle, detektieren kann, den Andockvorgang erkennen und digital speichern. Durch wiederholtes Durchströmen unterschiedlicher Markermoleküle, kann das gesamte Makromolekül erfindungsgemäß sequenziert werden. Die erfindungsgemäße Prägemasse und die daraus entstehenden Prägeprodukte werden die Herstellung, Strukturierung und Effizienz derartiger Mikrofluidbaugruppe entscheidend steigern.

Gemäß einer dritten, insbesondere eigenständigen, Ausführungsform wird die erfindungsgemäße Prägemasse zur Herstellung von optischen Elementen verwendet, die für sich alleine genommen bereits voll funktionstüchtig sind und die ihnen zugedachte Aufgabe erfüllen. Darunter fallen vor allem konvexe und konkave Linsen, diffraktive optische Elemente (engl.: diffractive optical elements, DOE) wie beispielsweise Fresnellinsen, Beugungsgitter, Phasengitter. Mit besonderem Vorzug können die so durch einen Prägeschritt hergestellten optischen Elemente über einer funktionalen Einheit, wie beispielsweise einem Bildsensor, einer Kamera, einem CCD Detektor, einer LED, einem Laserdiode, einer Photodiode, einem Temperatursensor angeordnet werden. Die erzielten optischen Effekte der hergestellten optischen Elemente, nämlich die Veränderung der Intensität, Phase und Richtung der einfallenden bzw. ausfallenden elektromagnetischen Strahlen, werden so direkt mit einer Auswerteeinheit (Photodiode, Bildsensor, etc.) bzw. Erzeugungseinheit (LED, Laserdiode, etc.) kombiniert.

In einher vierten, insbesondere eigenständigen, Ausführungsform wird die erfindungsgemäße Prägemasse als Ätzmaske verwendet. Dabei wird die erfindungsgemäße Prägemasse in einem ersten Schritt über einer zu ätzenden Oberfläche aufgetragen. Danach erfolgt in einem zweiten Schritt die Strukturierung der erfindungsgemäßen Prägemasse durch einen Prägestempel. Die Strukturierung kann dabei entweder auf die Art erfolgen, dass die von der verwendeten Ätzflüssigkeit zu erreichenden Stellen der Substratoberfläche vollkommen von der erfindungsgemäßen Prägemasse befreit sind. Eine bevorzugte Art der Ätzmaskenherstellung besteht darin, dass die von der verwendeten Ätzflüssigkeit zu erreichenden Stellen der Substratoberfläche noch zumindest teilweise mit einer erfindungsgemäßen Prägemasse bedeckt bleiben.

In einem dritten Prozessschritt erfolgt dann die Aushärtung der erfindungsgemäßen Prägemasse, gefolgt von der Ätzung der erfindungsgemäßen Prägemasse. Dabei wird zwar die gesamte erfindungsgemäße Prägemasse angegriffen, allerdings erreicht die Ätzchemikalie die eigentlich zu ätzende Substratoberfläche an den entsprechend korrekt strukturierten Stellen schneller, da die Dicke der erfindungsgemäßen Prägemasse dort, insbesondere um ein vielfaches, geringer ist. Nach der Ätzung der erfindungsgemäßen Prägemasse durch eine entsprechende Chemikalie, kann dann die Ätzung der eigentlichen Oberfläche mit einer, im Allgemeinen zur ersten Ätzchemikalie unterschiedlichen, zweiter Ätzchemikalie erfolgen. Nach der erfolgreichen Ätzung wird die erfindungsgemäße Prägemasse vollständig durch die erste Ätzchemikalie von der Oberfläche des zu ätzenden Substrats entfernt.

In einer ganz besonderen, insbesondere eigenständigen, Ausführungsform kann ein Prägestempel verwendet werden, der nur an einigen Stellen mit einem für elektromagnetische Strahlen opaken Material beschichtet wurde. Beleuchtet man die erfindungsgemäße Prägemasse durch den Prägestempel, blockieren die mit dem für elektromagnetische Strahlen opaken Material beschichteten Stellen die elektromagnetische Strahlung und verhindern so die Aushärtung der darunterliegenden erfindungsgemäßen Prägemasse. Durch diesen speziell präparierten Prägestempel erübrigt sich, im idealsten Fall, eine Ätzung der ausgehärteten Prägemasse durch aggressive Chemikalien, da die nicht ausgehärteten Stellen der erfindungsgemäßen Prägemasse durch weniger aggressive Chemikalien entfernt werden können. Nachdem die Ätzmaske aus der erfindungsgemäßen Prägemasse hergestellt wurde kann wiederum die Oberfläche des Substrats mit den entsprechenden Chemikalien geätzt werden. In einem letzten Prozessschritt wird die Ätzmaske durch entsprechende Chemikalien entfernt.

In einer fünften, insbesondere eigenständigen, Ausführungsform wird die erfindungsgemäße Prägemasse verwendet, um daraus einen Prägestempel zu prägen/herzustellen. Ein Prägestempel, der auf der erfindungsgemäßen Prägemasse basiert, weist alle oben genannten Vorteile auf.

In einer sechsten, insbesondere eigenständigen, Ausführungsform wird die erfindungsgemäße Prägemasse durch ein Kontaktlithographieverfahren übertragen. Dabei wird einerseits ausgenutzt, dass die Adhäsion zwischen erfindungsgemäßer Prägemasse und Prägestempel bei der Aufnahme der erfindungsgemäßen Prägemasse hoch genug ist um die erfindungsgemäße Prägemasse am Prägestempel anzuhaften. Andererseits wird die Adhäsion zwischen der erfindungsgemäßen Prägemasse und der Oberfläche des zu beprägenden Substrats größer sein als die Adhäsion zwischen erfindungsgemäßer Prägemasse und Prägestempel, sodass eine einseitige Übertragung der erfindungsgemäßen Prägemasse denkbar ist. Mit Vorzug werden mehr als 50% der Prägemasse übertragen. Mit besonderem Vorzug wird dabei die einstellbare Adhäsion in der erfindungsgemäßen Prägemasse über die korrekte Wahl der Nebenkomponente(n), deren chemische Struktur, Menge, chemisches und/oder physikalisches Bindungsverhalten ausgenutzt.

In einer siebten, insbesondere eigenständigen, Ausführungsform wird die erfindungsgemäße Prägemasse als Schutzschicht mit Durchkontaktierungen verwendet. Dabei wird die erfindungsgemäße Prägemasse über entsprechenden Kontakten durch einen Ätzprozess geöffnet. Die erfindungsgemäße Prägemasse dient dann als dielektrische Schicht mit geöffneten Kontaktierungszugängen.

In einer achten, insbesondere eigenständigen, Ausführungsform ist die Verwendung der erfindungsgemäßen Prägemasse als Maske für einen Transferätzprozess denkbar. Darunter versteht man, dass zuerst die Prägemasse über einem eigentlichen zu strukturierenden Substrat in der Form geprägt wird, die später das zu strukturierende Substrat aufweisen soll/wird. Denkbar wäre insbesondere die Prägung einer Linse mit der erfindungsgemäßen Prägemasse auf einem Siliziumsubstrat. Durch einen chemischen und/oder physikalischen Ätzprozess wird die erfindungsgemäße Prägemasse kontinuierlich weggeätzt. Da die Schichtdicke der erfindungsgemäßen Prägemasse inhomogen ist, wird an Stellen mit geringerer erfindungsgemäßer Prägemasse das zu ätzende Substrat früher von der Ätzchemikalie erreicht bzw. in einem physikalischen Ätzprozess früher von den Sputteratomen und/oder Sputtermolekülen erreicht. Damit beginnt der Ätzvorgang an einigen Stellen früher als an anderen Stellen. Es zeigt sich, dass bei einer Ätzisotropie der erfindungsgemäßen Prägemasse (die auf Grund des amorphen Charakters der erfindungsgemäßen Prägemasse praktisch immer vorhanden ist) die in die erfindungsgemäße Prägemasse eingeprägte Form direkt in das darunterliegende Substrat übertragen werden kann. Bei unterschiedlichen Ätzraten zwischen Prägemasse und zu ätzendem Material unterscheiden sich die Strukturen in der Prägemasse von den zu erzeugenden Strukturen im Substrat. Transferätzprozesse eignen sich vor allem zur Strukturierung von Materialien, die nicht auf konventionelle Art geformt werden können. Beispielsweise ist es, vor allem in der Infrarotoptik, von sehr großer Bedeutung, Siliziumlinsen herzustellen. Silizium besitzt im Wellenlängenbereich der Infrarotstrahlung einen Brechungsindex von mehr als 3.5, wohingegen der Brechungsindex von Quarzglas im gleichen Wellenlängenbereich nur um die 1.45 beträgt.

Weitere denkbare Materialien, die durch die Ausführungsform hergestellt werden könnten und entsprechend hohe Brechungsindizes besitzen, sind CaF, ZnS, Sapphir, Germanium, BaF, ZnSe. Das Auflösungsvermögen einer Linse ist umso besser, je kleiner die verwendete Wellenlänge und je größer die numerische Apertur ist. Die numerische Apertur ist das Produkt aus dem Sinus des Akzeptanzwinkels und des Brechungsindex. Je größer der Brechungsindex eines Materials, desto größer ist also die mögliche Auflösung bei konstantem Akzeptanzwinkel und konstanter Wellenlänge. Daher ist Silizium ein für den Infrarotbereich viel besser geeignetes Material als Quarzglas. Leider lässt es sich nicht so einfach durch entsprechende Nasschemische Prozesse herstellen, sondern ist entweder als Einkristall oder als poly-Silizium, also als Polykristall, in Verwendung. Entsprechend einfach würde sich die Strukturierung des Siliziums mit dem offenbarten Transferätzprozesses gestalten. Den Transferätzprozess kann man auch mit Erfolg verwenden, um Patterned Sapphire Substrats (PSS) oder Nano Patterned Sapphire Substrats (nPSS) herzustellen. Dabei handelt es sich um strukturierte Saphirsubstrate, die vor allem in der Herstellung von hocheffizienten LEDs zum Einsatz kommen,

Weitere Merkmale und Ausführungsformen der Erfindung ergeben sich aus den Ansprüchen sowie der nachfolgenden Figurenbeschreibung zur Zeichnung. Die Zeichnung zeigt in:
- Figur 1: eine schematische Querschnittsdarstellung einer ersten Verwendungsform einer ersten Verwendungsform einer erfindungsgemäßen Prägemasse,
- Figur 2: eine schematische Querschnittsdarstellung einer zweiten Verwendungsform einer erfindungsgemäßen Prägemasse,
- Figur 3: eine schematische Querschnittsdarstellung einer dritten Verwendungsform einer erfindungsgemäßen Prägemasse,
- Figur 4: eine schematische Querschnittsdarstellung einer vierten Verwendungsform einer Ätzmaske aus der Prägemasse,
- Figur 5: eine schematische Querschnittsdarstellung einer fünften Verwendungsform einer erfindungsgemäßen Prägemasse als Prägestempel,
- Figur 6: eine schematische Querschnittsdarstellung einer sechsten Verwendungsform einer erfindungsgemäßen Prägemasse bei der Kontaktlithographie,
- Figur 7: eine schematische Querschnittsdarstellung einer siebten Verwendungsform einer erfindungsgemäßen Prägemasse als örtlich begrenzte, durchgeätzte Isolierschicht und
- Figur 8: eine schematische Querschnittsdarstellung einer achten Verwendungsform einer erfindungsgemäßen Prägemasse als Transferätzmaske.

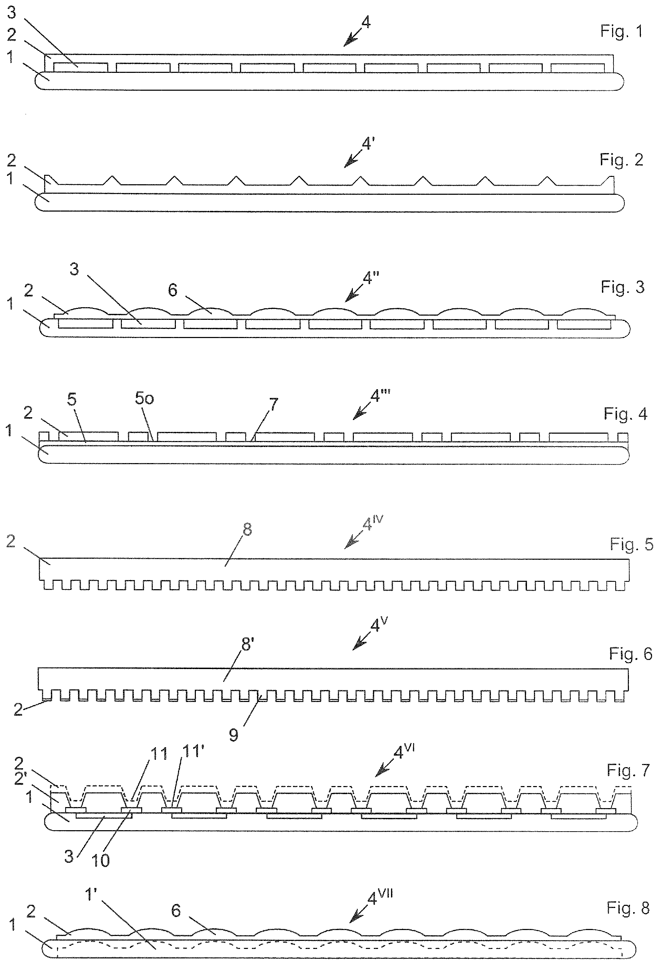

Figur 1 zeigt eine erste Verwendung der erfindungsgemäßen Prägemasse 2 zur Einkapselung bzw. zum Schutz funktionaler Einheiten 3 auf einem Substrat 1 durch Urformung einer ersten Prägeform 4.

Figur 2 zeigt eine zweite Verwendung der erfindungsgemäßen Prägemasse 2 als Grundmaterial und Konstruktionsmaterial durch Urformung einer zweiten Prägeform 4'.

Figur 3 zeigt eine dritte Verwendung der erfindungsgemäßen Prägemasse 2 zur Herstellung von optischen Elementen 6 über funktionellen Einheiten 3. Die optischen Elemente 6 können dabei mit Vorzug direkt über den funktionalen Einheiten 3 durch Urformung einer dritten Prägeform 4" geprägt werden.

Figur 4 zeigt eine vierte Verwendung der erfindungsgemäßen Prägemasse 2 als Ätzmaske mit bereits vorhandenen Durchkontaktierungen 7 durch Urformung einer vierten Prägeform 4"'. Die Durchkontaktierungen 7 reichen bis zur Oberfläche 5o der zu ätzenden Schicht 5.

Figur 5 zeigt eine fünfte Verwendung der erfindungsgemäßen Prägemasse 2 als Stempel 8 durch Urformung einer fünften Prägeform 4^{IV}.

Figur 6 zeigt eine sechste Verwendung der erfindungsgemäßen Prägemasse 2 als Prägematerial auf den Prägestrukturen 9 eines Stempel 8' in einer sechsten Prägeform 4^{V}.

Figur 7 zeigt eine siebte Verwendung der erfindungsgemäßen Prägemasse 2. In einem ersten Prozessschritt, einem Prägeschritt, erfolgt eine Strukturierung der auf dem Substrat 1 aufgebrachten Prägemasse 2 in der Art und Weise, dass die Prägemasse 2 noch nicht geöffnete Kontaktierungszugänge 11 über elektrisch leitfähigen Kontakten 10 besitzt. Die Kontakte 10 sind beispielsweise mit den funktionalen Einheiten 3 verbunden. In einem zweiten Prozessschritt, einem Ätzschritt, wird die Prägemasse 2 so lange geätzt, bis die noch nicht geöffneten Kontaktierungszugänge 11 vollständig zu den Kontaktierungszugängen 11' geätzt wurden. Die Kontaktierungszugänge 11' reichen an die Kontakte 10 heran. In weiteren, nicht dargestellten Prozessschritten kann danach eine Beschichtung der Prägemasse 2' mit einem leitfähigen Material erfolgen, welches die Kontakte 10 mit der Oberfläche der Prägemasse 2' verbindet oder Verbindungen zu einzelnen Kontakten ermöglicht.

Figur 8 zeigt eine achte Verwendung der erfindungsgemäßen Prägemasse 2 als Transferätzmaske. In einem ersten Prozessschritt wird die erfindungsgemäße Prägemasse 2 strukturiert. In Figur 8 erkennt man eine beispielhafte Strukturierung in Form mehrerer Linsen 6. Die strukturierte erfindungsgemäße Prägemasse 2 befindet sich auf einem eigentlich zu ätzenden Substrat 1. Durch einen nicht dargestellten Ätzprozess wird das Substrat 1 zum geätzten Substrat 1'. Die Form der erfindungsgemäßen Prägemasse 2 wurde unter deren vollständiger Opferung in das Substrat 1 übertragen. Im gezeigten Beispiel ist die Ätzrate zwischen der Prägemasse 2 und dem Substrat 1 gleich. Sollten diese unterschiedlich sein, so ändert sich die Form der Struktur, im konkreten Beispiel der Linsen 6, bei der Übertragung.

### Prägemasse für die Prägelithographie

### BEZUGSZEICHENLISTE

- 1: Substrat
- 2, 2': Prägemasse
- 3, 3': Funktionale Einheit
- 4, 4', 4", 4"', 4^{IV}, 4^{V}, 4^{VI}, 4^{VII}: Prägeform
- 5: Schicht
- 6: Optische Elemente
- 7: Durchkontaktierung
- 8, 8': Stempel
- 9: Prägestrukturen
- 10: Kontakt
- 11, 11': Kontaktierungszugänge

## Patentansprüche

1. Kombination aus einem Stempel mit einer hydrophoben Stempeloberfläche und einer für die Prägelithographie verwendbaren, härtbaren Prägemasse mit einer hydrophoben Oberfläche, die Prägemasse bestehend aus einer Mischung aus:
- mindestens einer auf Siliziumoxid basierenden polymerisierbaren Hauptkomponente und
- mindestens einer Nebenkomponente zur Einstellung der Hydrophilität bzw. Hydrophobizität und
- einem Initiator und
- einem Lösungsmittel
**dadurch gekennzeichnet, dass** bei Aktivierung des Initiators nur die mindestens eine Hauptkomponente polymerisiert, wobei die, insbesondere anorganische, Hauptkomponente(n) aus mindestens einem der folgenden Materialien gebildet ist/sind:
• Polyhedrales oligomerisches Silsesquioxan (POSS)
• Poly(organo)siloxane (Silikon).

2. Kombination nach Anspruch 1, wobei die, insbesondere organische, Nebenkomponente(n) aus mindestens einer der folgenden Verbindungen besteht:
• Polyacrylate,
• Ether.

3. Kombination nach wenigstens einem der vorhergehenden Ansprüche, wobei die Prägemasse aus einer Kette von polymerisierten Monomeren, insbesondere mit einer Kettenlänge von mindestens zwei Monomeren, vorzugsweise mindestens 10 Monomeren, noch bevorzugter mindestens 100 Monomeren, noch bevorzugter mindestens 1000 Monomeren, besteht.

4. Kombination nach wenigstens einem der vorhergehenden Ansprüche, wobei die Prägemasse einen Massenanteil der Hauptkomponente(n) zwischen 50% und kleiner 100%, mit Vorzug zwischen 52% und 90%, mit größerem Vorzug zwischen 54% und 80%, mit größtem Vorzug zwischen 56% und 70% und die Nebenkomponente(n) 100% abzüglich dem Massenanteil der Hauptkomponente(n) aufweisen.

## Claims

1. Combination of a stamp with a hydrophobic stamp surface and an embossing material that can be hardened and used for embossing lithography with a hydrophobic surface, the embossing material consisting of a mixture of:
- At least one polymerizable main component based on silicon oxide, and
- At least one secondary component for setting the hydrophilicity respectively the hydrophobicity, and
- an initiator and
- a solvent,
**characterized in that** in the case of activation of the initiator only the at least one main component polymerizes, wherein the, especially anorganic, main component(s) is/are formed from at least one of the following materials:
- Polyhedral, oligomeric silsesquioxane (POSS)
- Poly(organo)siloxane (silicone).

2. Combination according to Claim 1, whereby the secondary component(s), which is/are in particular inorganic, is/are formed from at least one of the following materials:
• Polyacrylate,
• Ether.

3. Combination according to one of Claims 1 or 2, wherein the embossing material consists of a chain of polymerized monomers, in particular with a chain length of at least two monomers, preferably at least 10 monomers, more preferably at least 100 monomers, and even more preferably at least 1,000 monomers.

4. Combination according to one of the preceding Claims, whereby the embossing material comprises a proportion by weight of the main component(s) of between 50% and less than 100%, preferably between 52% and 90%, more preferably between 54% and 80%, most preferably between 56% and 70%, and the secondary component(s) comprise(s) 100% minus the proportion by weight of the main component(s).

## Revendications

1. Combinaison d'un poinçon comprenant une surface de poinçon hydrophobe et une masse de gaufrage durcissable pouvant être employée pour la lithographie par gaufrage, la masse de gaufrage étant composée d'un mélange de :
- au moins une composante principale pouvant être polymérisée à base d'oxyde de silicium et
- au moins une composante secondaire pour régler hydrophilie, respectivement, l'hydrophobie et
- un promoteur et
- un solvant
**caractérisé en ce que** lors de l'activation du promoteur, seule l'au moins une composante principale est polymérisée, dans lequel
la/les composante(s) principale(s), en particulier anorganique(s), est/sont formées d'au moins un des matériaux suivantes :
- Polyhedral Oligomeric Silsesquioxane (POSS)
- poly(organo)siloxane (silicone).

2. Combinaison selon la revendication 1, dans lequel la/les composante(s)secondaire(s), en particulier organique(s), est/sont composée(s) d'au moins une des liaisons suivantes :
- polyacrylate,
- éther.

3. Combinaison selon au moins l'un des revendications précédentes, dans lequel la masse de gaufrage est composée d'au moins une chaîne de monomères polymérisés, en particulier avec une longueur de chaîne d'au moins deux monomères, de préférence d'au moins 10 monomères, plus encore de préférence d'au moins 100 monomères, plus encore de préférence d'au moins 1000 monomères.

4. Combinaison selon au moins l'un des revendications précédentes, dans lequel la masse de gaufrage présente une part massique de la/les composante(s) principale (s) entre 50 % et inférieure à 100 %, de préférence entre 52 % et 90 %, avec une plus grande préférence entre 54 % et 80 %, avec la plus grande préférence entre 56 % et 70 % et la/les composante(s)secondaire(s) 100 % déduction faite de la part massique de la/les composante(s) principale(s).
